Europäisches Patentamt

(19) **European Patent Office**

**Office européen des brevets**

(11) Veröffentlichungsnummer: **0 057 832**
**B1**

(12) # EUROPÄISCHE PATENTSCHRIFT

(45) Veröffentlichungstag der Patentschrift:
02.01.85

(51) Int. Cl.³: **H 01 F 17/06**

(21) Anmeldenummer: **82100380.3**

(22) Anmeldetag: **21.01.82**

(54) **Funkentstöranordnung und Verfahren zur Herstellung.**

(30) Priorität: **07.02.81 DE 3104270**

(43) Veröffentlichungstag der Anmeldung:
**18.08.82 Patentblatt 82/33**

(45) Bekanntmachung des Hinweises auf die Patenterteilung:
**02.01.85 Patentblatt 85/1**

(84) Benannte Vertragsstaaten:
**CH DE FR GB IT LI**

(56) Entgegenhaltungen:
**AT - B - 293 566**
**AT - B - 301 714**
**DE - A - 2 050 312**

(73) Patentinhaber: **VACUUMSCHMELZE GMBH, Grüner Weg 37, D-6450 Hanau 1 (DE)**

(72) Erfinder: **Müllenheim, Thomas, Dipl.-Ing., Königsbergerstrasse 9, D-8756 Kahl/Main (DE)**
Erfinder: **Nilius, Hans-Joachim, Leipzigerstrasse 29, D-6453 Seligenstadt/Main (DE)**

## Beschreibung

Die Erfindung betrifft eine Funkentstöranordnung, die in einem mit Isoliermaterial ausgegossenen Behälter angeordnet ist, mit einer Drossel, bestehend aus einem Ringkern aus weichmagnetischem Material, auf den mindestens zwei vom Netzstrom in entgegengesetzten Richtungen durchflossene Wicklungen aufgebracht sind, wobei im Behälter in der Nähe der Drossel magnetisch leitendes Material angeordnet ist.

Beispielsweise aus der DE-U-7 037 848 ist eine Funkentstöranordnung bekannt, die eine stromkompensierte Mehrfachdrossel enthält. Hier werden auf einem ringförmigen Kern mindestens zwei Wicklungen aufgebracht. Diese Wicklungen werden vom Betriebsstrom so durchflossen, daß sich die magnetischen Wirkungen des hin- und rückfließenden Betriebsstromes im Ringkern gegenseitig aufheben. Hierdurch läßt sich für erdunsymmetrische Störströme eine hohe Dämpfung erzielen, die in Verbindung mit zwischen den Leitern und der Erde angeordneten Kondensatoren noch verbessert werden kann. Da erdsymmetrische Störströme sich in ihrer magnetischen Wirkung im Kern wie die Betriebsströme aufheben, wird zur Dämpfung der erdsymmetrischen Ströme eine Erhöhung der Streuinduktivität der Funkentstördrossel vorgesehen. Zur Erhöhung dieser Streuinduktivität wird die Drossel in einem Behälter aus elektrisch leitendem Material angeordnet und es werden gegebenenfalls unterhalb oder im Mittelpunkt des Ringkernes zusätzlich magnetisch leitende Teile vorgesehen.

Aufgabe der vorliegenden Erfindung ist es demgegenüber, eine Funkentstöranordnung zu erreichen, die einfacher herzustellen und zu dimensionieren ist und bei gleicher Leistung ein verringertes Bauvolumen zuläßt.

Die Lösung dieser Aufgabe besteht erfindungsgemäß darin, daß als magnetisch leitendes Material magnetisch leitendes Pulver verwendet wird, das in die Vergußmasse eingebettet ist.

Während bei bekannten Funkentstöranordnungen zur Einstellung der Streuinduktivität zwischen die zusätzlich vorgesehenen Teile aus magnetisch leitendem Material und der Drossel ein definierter Abstand eingehalten werden muß, läßt sich die Streuinduktivität bei der Verwendung der Einbettung der Drossel in Pulver aus magnetisch leitendem Material durch Wahl der Korngröße des Pulvers bzw. durch das Mischungsverhältnis zwischen dem Pulver und der isolierenden Vergußmasse festlegen. Dies bedingt eine wesentliche Vereinfachung bei der Herstellung. Außerdem ergibt sich durch das die Drossel vollständig umgebende Pulver eine nach allen Seiten wirksam verbesserte Wärmeleitfähigkeit, so daß eine höhere Belastbarkeit der Drosselwicklungen bei gleichen Abmessungen gegeben ist. Weiterhin wird bei der erfindungsgemäßen Anordnung erreicht, daß der sich bildende Streufluß auf einen großen, die gesamte Hüllfläche der Wicklung umfassenden Querschnitt verteilt wird. Auch hierdurch ist ein höherer Strom gegenüber der bekannten Anordnung zulässig, da die Sättigungsinduktion wegen des größeren, dem Streufluß zur Verfügung stehenden Querschnittes erst bei höheren Betriebsströmen erreicht wird.

Ein Ausführungsbeispiel ist in den Fig. 1 und 2 in zwei Schnitten dargestellt. Fig. 3 zeigt das Schaltbild der an ein Schaltnetzteil angeschlossenen Funkentstöranordnung.

Die Funkentstöranordnung 1 ist an die Klemmen 2 und 3 eines Wechselstromnetzes angeschlossen und besitzt Ausgangsklemmen 4 und 5, die mit einem Gleichrichter 6 in Verbindung stehen. Der gleichgerichtete Strom gelangt in bekannter Weise an einen Zerhacker, bestehend aus einem Kondensator 7, Thyristoren 8 und 9, einem Transformator 10 mit nachgeschalteten Dioden 11 und 12 und einem Glättungsglied, bestehend aus einer Längsdrossel 13 und einem Querkondensator 14. An den Ausgangsklemmen 15 und 16 des Schaltnetzteiles steht dann eine gleichgerichtete Spannung gewünschter Größe an.

Die Funkentstöranordnung 1 besteht im einzelnen aus einem Entladewiderstand 17, der zwischen die Klemmen 2 und 3 geschaltet ist, aus den Wicklungen 18 und 19 einer stromkompensierenden Drossel 20 mit einem Ringkern 21, auf den die Wicklungen 18 und 19 so aufgewickelt sind, daß sich die durch die Betriebsströme hervorgerufenen Induktionen im Ringkern 21 kompensieren. Die freien Enden der Wicklungen 18 und 19 sind über Leitungen 22 und 23 an die Ausgangsklemmen 4 und 5 der Funkentstöranordnung 1 geführt. Zwischen den Leitungen 22 und 23 und zwischen diesen Leitungen und der Erde befindet sich je ein Kondensator 24 bis 26. Die Funkentstöranordnung ist in einem mit Vergußmasse, z. B. Gießharz, vergossenen Außenbehälter 27 angeordnet. In diesem kann sich ein weiterer Behälter 28 befinden, der nur die Drossel 20 aufnimmt.

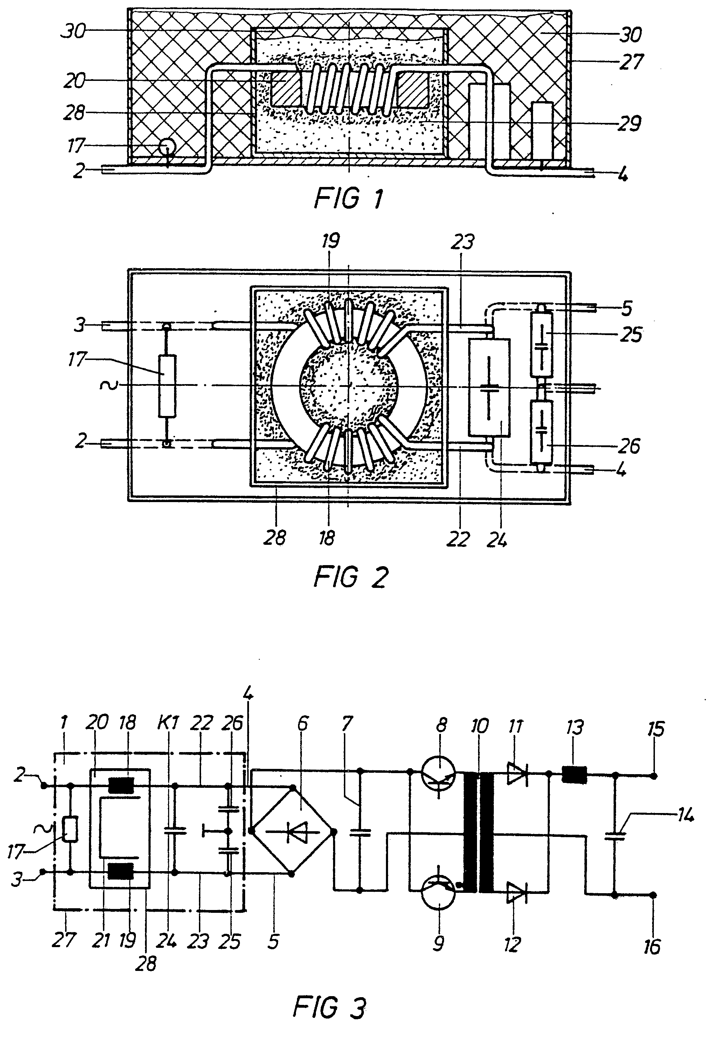

Durch die schnell ein- und ausschaltbaren Thyristoren 8 und 9 entstehen hochfrequente Ströme und Spannungen, die durch die Funkentstöranordnung vom elektrischen Netz ferngehalten werden sollen. Außerdem sollen durch die Funkentstöranordnung vom Netz herkommende, hochfrequente Störströme unterdrückt werden. Um auch die erdsymmetrischen Ströme gut zu dämpfen, die wie der Betriebsstrom zwischen den Leitungen 22 und 23 fließen, ist es vorteilhaft, wenn die Drossel 20 innerhalb der Funkentstöranordnung eine hohe Streuinduktivität besitzt, ohne daß die Induktivität bezüglich des unsymmetrischen Störstromes vermindert wird. Hierzu wird, wie Fig. 1 und 2 zeigen, die Drossel 20 in Eisenpulver 29 eingebettet, das von der Wand des Behälters 28 bzw. der Vergußmasse 30 umschlossen ist.

Zur Herstellung der Drossel mit erhöhter Streuinduktivität kann die bewickelte Drossel erfindungsgemäß einfach in eine bestimmte Menge von Eisenpulver eingebettet werden. Anschließend wird die gesamte Funkentstöranordnung mit isolierender Vergußmasse vergossen.

Der Ringkern kann aus einer Nickel-Eisen-Legierung mit 40—80% Nickel bestehen.

Für den Fall, daß die Funkentstöranordnung höhere Spannungen aushalten soll, kann man mit besonderem Vorteil die Vergußmasse für die Drossel in flüssigem Zustand mit Eisenpulver oder Pulver aus anderen weichmagnetischen Materialien mischen und dieses Gemisch zum Vergießen der gesamten Funkentstöranordnung oder nur des Behälters 28 verwenden. In diesem Fall sind auch bereits in der Nähe der Drossel Isolationsabstände zwischen den einzelnen Partikeln des Eisenpulvers vorhanden, so daß eventuell auch die Isolierung der Wicklungen vermindert werden kann, oder gar überflüssig ist.

**Patentansprüche**

1. Funkentstöranordnung (1), die in einem mit Isoliermaterial ausgegossenen Behälter (28) angeordnet ist, mit einer Drossel (20), bestehend aus einem Ringkern (21) aus weichmagnetischem Material, auf den mindestens zwei vom Netzstrom in entgegengesetzten Richtungen durchflossene Wicklungen (18, 19) aufgebracht sind, wobei im Behälter in der Nähe der Drossel (20) magnetisch leitendes Material angeordnet ist, dadurch gekennzeichnet, daß als magnetisch leitendes Material magnetisch leitendes Pulver verwendet wird, das in die Vergußmasse (30) eingebettet ist.

2. Verfahren zur Herstellung einer Funkentstöranordnung nach Anspruch 1, dadurch gekennzeichnet, daß die Drossel (20) in einen Behälter (28) eingebracht, in Pulver (29) aus magnetisch leitendem Material eingebettet und der Behälter (28) anschließend mit isolierendem Material (Gießharz) vergossen wird.

3. Verfahren zur Herstellung einer Funkentstöranordnung nach Anspruch 1, dadurch gekennzeichnet, daß die Drossel (20) in einem Behälter (28) mit Hilfe einer Mischung aus isolierender Vergußmasse (30) mit magnetisch leitendem Pulver (29) vergossen wird.

4. Funkentstöranordnung nach Anspruch 1, dadurch gekennzeichnet, daß der die vergossene Drossel (20) aufnehmende Behälter (28) in einem in weiteren Behälter (27) aus isolierendem Material angeordnet ist, in dem auch die übrigen Teile (17, 24—26) der Funkentstöranordnung untergebracht sind.

5. Funkentstöranordnung nach Anspruch 1, dadurch gekennzeichnet, daß der Ringkern (21) aus einer Nickel-Eisen-Legierung mit 40 bis 80% Nickel besteht und als magnetisch leitendes Pulver Eisenpulver vorgesehen ist.

**Claims**

1. A radio interference suppression arrangement (1) which is arranged in a container (28) filled up with cast insulating material, comprising a choke (20) consisting of an annular core (21) made of softmagnetic material on which are arranged at least two windings (18, 19) which are traversed by the mains current in opposite directions, magnetically conductive material being arranged in the container in the vicinity of the choke (20), characterised in that magnetically conductive powder which is embedded into the cast filling compound (30) is used as magnetically conductive material.

2. A process for the production of a radio interference suppression arrangement as claimed in Claim 1, characterised in that the choke (20) is introduced into a container (28), embedded in powder (29) consisting of magnetically conductive material, and the container (28) is then filled up with insulating material (casting resin).

3. A process for the production of a radio interference suppression arrangement as claimed in Claim 1, characterised in that the choke (20) is potted in a container (28) with the aid of a mixture of insulating filling compound (30) with magnetically conductive powder (29).

4. A radio interference suppression arrangement as claimed in Claim 1, characterised in that the container (28) which accommodates the potted choke (20) is arranged in a further container (27) of insulating material in which the other parts (17, 24 to 26) of the radio interference suppression arrangement are also accommodated.

5. A radio interference suppression arrangement as claimed in Claim 1, characterised in that the annular core (21) consists of a nickel-iron alloy containing 40 to 80% nickel, and iron powder is provided as the magnetically conductive powder.

**Revendications**

1. Dispositif pour l'élimination des parasites d'émissions radio, disposé dans un caisson coulé en matériau isolant (28), avec un élément d'inductance d'étranglement (20) consistant en un noyau annulaire (21) en matériau à magnétisme doux, entre lequel sont montés au moins deux enroulements (18—19), traversés en direction opposées par le courant du réseau, un matériau magnétiquement conducteur étant disposé dans le caisson au voisinage de l'étranglement (20), dispositif caractérisé en ce que, comme matériau magnétiquement conducteur, est utilisée une poudre magnétiquement conductrice qui est incorporée dans une masse coulée (30).

2. Procédé pour la fabrication d'un dispositif anti-parasites conforme à la revendication 1, procédé caractérisé en ce qu'on place l'inductance d'étranglement (20) dans un caisson (28), on l'enrobe dans une poudre (29) en matériau magnétiquement conducteur et on coule ensuite dans le caisson (28) un matériau isolant (résine coulée).

3. Procédé pour la fabrication d'un dispositif anti-parasites pour émissions radio suivant la revendication 1, caractérisé en ce que l'inductance d'étranglement (20) est enrobée avec la poudre magnétiquement conductrice à l'aide d'un mélange constitué par une masse coulée isolante (30).

4. Dispositif anti-parasites de radio suivant la revendication 1, caractérisé en ce que le caisson (28) qui reçoit l'inductance d'étranglement coulée (20) est disposé dans un autre caisson (27) en matériau isolant dans lequel sont montés les autres éléments (17, 24 à 26) du dispositif anti-parasites.

5. Dispositif anti-parasites de radio suivant la revendication 1, caractérisé en ce que le noyau annulaire (21) est constitué en un alliage nickel-fer contenant de 40 à 80% de nickel et en ce qu'on utilise, comme poudre magnétiquement conductrice, de la poudre de fer.

FIG 1

FIG 2

FIG 3